# EUROPEAN PATENT APPLICATION

(11) **EP 4 343 857 A1**
(43) Date of publication of application: **27.03.2024**
(21) Application number: 21956366.5
(22) Date of filing: 09.09.2021
(51) Int. Cl.: H01L 31/0224, H02J 7/35, G02C 11/00

(54) **SOLAR CELL DEVICE AND MANUFACTURING METHOD THEREFOR, AND ELECTRONIC DEVICE**

(71) Applicant: Huawei Technologies Co., Ltd., Shenzhen, Guangdong 518129 (CN)
(72) Inventor: LUO, Qun, Suzhou, Jiangsu 215123 (CN); WANG, Shuo, Shenzhen, Guangdong 518129 (CN); SU, Wenming, Suzhou, Jiangsu 215123 (CN); CHEN, Xiaolian, Suzhou, Jiangsu 215123 (CN); XIN, Kai, Shenzhen, Guangdong 518129 (CN); LIU, Yunfeng, Shenzhen, Guangdong 518129 (CN)
(74) Representative: Gill Jennings & Every LLP
(86) International application number: PCT/CN2021/117432
(87) International publication number: WO 2023/035180

(57) **Abstract**

Embodiments of this application disclose a solar cell component, a manufacturing method thereof, and an electronic device. The solar cell component may include a first electrode, a second electrode, and a light absorption layer. The first electrode includes a first conductive electrode, and the second electrode includes a second conductive electrode. The light absorption layer is located between the first conductive electrode and the second conductive electrode. The first electrode further includes a first bus electrode. The first bus electrode is connected to a periphery of the first conductive electrode, and a sheet resistance of the first bus electrode is less than a sheet resistance of the first conductive electrode. In other words, a sheet resistance of a peripheral region of the first electrode is less than a sheet resistance of a central region of the first electrode. In this way, compared with a case in which a first electrode includes only a single first conductive electrode, a sheet resistance of the first electrode is reduced. After an optical charge is transmitted to the first conductive electrode, the optical charge can be quickly converged to the periphery, thereby reducing a sheet resistance loss caused by long-distance uneven transmission of the optical charge, and facilitating collection of the optical charge. Therefore, optical-to-electrical conversion efficiency of the solar cell component can be improved.

## Description

### TECHNICAL FIELD

This application relates to the field of semiconductor manufacturing technologies, and in particular, to a solar cell component, a manufacturing method thereof, and an electronic device.

### BACKGROUND

An organic solar cell has characteristics of light weight, low cost, flexibility, semitransparency, and large area. The organic solar cell has a broad application prospect in the future, such as multi-functional self-power supply and building photovoltaic integration. With the emergence of the smart internet of things, characteristics of large area, lightness, and self-power supply of a smart internet of things device are widely concerned. For example, an organic solar cell may be disposed on smart glasses and a terminal display to implement self-power supply. Therefore, a large-area thin-film solar cell becomes a research hotspot.

In the large-area photovoltaic field, a transparent/semitransparent electrode has a significant function, directly affects charge collection of a component, and further affects optical-to-electrical conversion efficiency of the component. How to effectively improve optical-to-electrical conversion efficiency of a large-area thin-film solar cell by optimizing an electrode is an important problem in this field.

### SUMMARY

In view of this, embodiments of this application provide a solar cell component, a manufacturing method thereof, and an electronic device, to improve optical-to-electrical conversion efficiency of the component.

According to a first aspect of embodiments of this application, a solar cell is provided. The solar cell includes a first electrode, a second electrode, and a light absorption layer. The first electrode includes a first conductive electrode, and the second electrode includes a second conductive electrode. The light absorption layer is located between the first conductive electrode and the second conductive electrode. The first electrode further includes a first bus electrode. The first bus electrode is connected to a periphery of the first conductive electrode, and a sheet resistance of the first bus electrode is less than a sheet resistance of the first conductive electrode. The first bus electrode is electrically connected to the first conductive electrode. The first electrode may be a bottom electrode or a top electrode. In other words, a sheet resistance of a peripheral region of the first electrode is less than a sheet resistance of a central region of the first electrode. In this way, compared with a case in which a first electrode includes only a single first conductive electrode, a sheet resistance of the first electrode is reduced. After an optical charge is transmitted to the first conductive electrode, the optical charge can be quickly converged to the periphery, thereby reducing a sheet resistance loss caused by long-distance uneven transmission of the optical charge, and facilitating collection of the optical charge. Therefore, optical-to-electrical conversion efficiency of the solar cell component can be improved.

In some possible implementations, the second electrode further includes a second bus electrode, the second bus electrode is connected to a periphery of the second conductive electrode, and a sheet resistance of the second bus electrode is less than a sheet resistance of the second conductive electrode.

In this embodiment of this application, the electrodes located on both sides of the light absorption layer may each include a bus electrode. Compared with a case in which a first electrode and a second electrode each include only a single conductive electrode, a sheet resistance is reduced. A sheet resistance loss caused by long-distance uneven transmission of an optical charge is reduced, thereby facilitating collection of the optical charge.

In some possible implementations, the first bus electrode and the first conductive electrode are located on a same side of the light absorption layer, and the second bus electrode and the second conductive electrode are located on the other side of the light absorption layer.

In this embodiment of this application, the first bus electrode and the first conductive electrode may be located on the same side of the light absorption layer, and the second bus electrode and the second conductive electrode may be located on the other side of the light absorption layer. In this way, a small distance exists between the first bus electrode and the first conductive electrode, and a small distance exists between the second bus electrode and the second conductive electrode, thereby reducing the sheet resistances of the two electrodes, and improving optical charge collection efficiency.

In some possible implementations, the light absorption layer is further located between the first bus electrode and the second bus electrode.

In this embodiment of this application, the light absorption layer may be located between the first bus electrode and the second bus electrode. Some carriers in the light absorption layer may be directly transmitted to the first bus electrode and the second bus electrode on the two sides, and do not need to be transmitted to the first bus electrode through the first conductive electrode or transmitted to the second bus electrode through the second conductive electrode, thereby shortening a transmission path, reducing a transmission loss, and improving optical charge collection efficiency.

In some possible implementations, the component further includes a substrate, the first conductive electrode is in contact with the substrate, the second conductive electrode is far away from the substrate, the second conductive electrode includes a second conductive grid, and the second conductive grid is configured to enhance a conductivity of the second conductive electrode.

In this embodiment of this application, the top electrode may be an electrode far away from the substrate of the component, and also be an electrode formed after the light absorption layer. When the second conductive electrode is used as a top electrode, the second conductive electrode may include a conductive grid, and therefore has a high conductivity.

In some possible implementations, the second conductive electrode further includes a second conductive modification layer, and the second conductive modification layer is located on a side that is of the second conductive grid and that faces the light absorption layer, and is configured to increase flatness of a surface that is of the second conductive electrode and that faces the light absorption layer.

In this embodiment of this application, the second conductive electrode may further include the second conductive modification layer. The second conductive modification layer may modify an interface of the side that is of the second conductive grid and that faces the light absorption layer, to increase flatness of the surface of the second conductive electrode and improve performance of the component.

In some possible implementations, the second conductive modification layer is made of at least one of the following types: a transparent conductive oxide, a metal nanowire, a conductive polymer, a carbon-based material, and a thin-film metal.

In this embodiment of this application, the second conductive modification layer is made of a material with a high conductivity. The transparent conductive oxide may be used for some materials to further reduce an interface barrier between the second conductive electrode and the light absorption layer, thereby improving carrier collection efficiency.

In some possible implementations, a first conductive adhesive is further included, where the first conductive adhesive is disposed between the second conductive grid and the light absorption layer, to increase conductivity efficiency between the second conductive grid and the light absorption layer.

In this embodiment of this application, the solar cell component may include the first conductive adhesive. The first conductive adhesive can ensure close mechanical contact and electrical contact of film layers on the two sides, thereby improving performance and reliability of the component.

In some possible implementations, the first bus electrode, the second bus electrode, and the first conductive electrode are located on a same side of the light absorption layer, the second conductive electrode is located on the other side of the light absorption layer, and the second conductive electrode is electrically connected to the second bus electrode through an interconnection structure.

In this embodiment of this application, the first bus electrode, the second bus electrode, and the first conductive electrode may be located on the same side of the light absorption layer, and the second conductive electrode is located on the other side of the light absorption layer. In this case, the first bus electrode and the second bus electrode may be formed through a same process. Compared with a conventional technology, an additional process is minimized, to simplify a process and reduce costs.

In some possible implementations, the second conductive electrode is parallel to the first conductive electrode, and the interconnection structure extends from the periphery of the second conductive electrode to the first conductive electrode, and is connected to the second bus electrode located on the periphery of the first conductive electrode.

In this embodiment of this application, the interconnection structure may be disposed on the periphery of the second conductive electrode, and is connected to the second bus electrode on the periphery of the first conductive electrode. In this way, the light absorption layer may be disposed between the second conductive electrode and the first conductive electrode, or may be disposed between the first bus electrode and the second conductive electrode. Some carriers in the light absorption layer may be conducted to the interconnection structure and the first bus electrode, thereby shortening a transmission path, reducing a transmission loss, and improving carrier collection efficiency.

In some possible implementations, the component further includes a substrate, both the first bus electrode and the second bus electrode are in contact with the substrate, the first bus electrode includes a third conductive grid, and the second bus electrode includes a fourth conductive grid.

In this embodiment of this application, the bottom electrode is an electrode close to the substrate, and is also an electrode formed before the light absorption layer. The top electrode is an electrode far away from the substrate, and is also an electrode formed after the light absorption layer. When the first conductive electrode is a bottom electrode, and the second conductive electrode is a top electrode, the first bus electrode and the second bus electrode may each include a conductive grid, and the second bus electrode and the first electrode are disposed on the same side of the light absorption layer. In this way, the first bus electrode and the second bus electrode may be simultaneously formed, and no additional step needs to be added to form the second bus electrode after the light absorption layer is formed, thereby reducing a quantity of processes.

In some possible implementations, the first conductive electrode includes a first conductive grid; or the first conductive electrode includes a first conductive grid and a first conductive modification layer located on a side that is of the first conductive grid and that faces the light absorption layer.

In this embodiment of this application, the first conductive electrode may include the first conductive grid, so that the first conductive electrode has a high conductivity and light transmittance. The first conductive electrode may further include the first conductive modification layer. The first conductive modification layer may modify an interface of the side that is of the first conductive grid and that faces the light absorption layer, to increase flatness of a surface of the first conductive electrode and improve performance of the component.

In some possible implementations, the first conductive modification layer is made of at least one of the following types: a transparent conductive oxide, a metal nanowire, a conductive polymer, a carbon-based material, and a thin-film metal.

In this embodiment of this application, the first conductive modification layer is made of a material with a high conductivity. The transparent conductive oxide may be used for some materials to further reduce an interface barrier between the first conductive electrode and the light absorption layer, thereby improving carrier collection efficiency.

In some possible implementations, a first carrier transport layer is disposed between the first electrode and the light absorption layer, and a second carrier transport layer is disposed between the second electrode and the light absorption layer.

In this embodiment of this application, the first carrier transport layer and the second carrier transport layer may be further disposed. One of the first carrier transport layer is an electron transport layer, and the other one is a hole transport layer. The two transport layers are configured to transmit corresponding carriers. In addition, a barrier between the electrode and the light absorption layer is reduced, thereby facilitating carrier collection.

In some possible implementations, the sheet resistance of the first conductive electrode is 5 to 1000 times the sheet resistance of the first bus electrode, and the sheet resistance of the second conductive electrode is 5 to 1000 times the sheet resistance of the second bus electrode.

In this embodiment of this application, the sheet resistance of the first bus electrode and the sheet resistance of the second bus electrode are reduced. Within this range, an appropriate material may be selected for disposing, thereby effectively improving carrier collection efficiency of the component and improving performance of the component.

In some possible implementations, the first bus electrode is made of at least one of the following types: a thin metal, a transparent conductive oxide, a metal nanowire, a conductive polymer, graphene, a carbon nanotube, and a conductive grid; the second bus electrode is made of at least one of the following types: a thin metal, a transparent conductive oxide, a metal nanowire, a conductive polymer, graphene, a carbon nanotube, and a conductive grid; the first conductive electrode is made of at least one of the following types: a thin metal, a transparent conductive oxide, a metal nanowire, a conductive polymer, a carbon-based material, and a conductive grid; and the second conductive electrode is made of at least one of the following types: a thin metal, a transparent conductive oxide, a metal nanowire, a conductive polymer, a carbon-based material, and a conductive grid.

In this embodiment of this application, the first bus electrode, the second bus electrode, the first conductive electrode, and the second conductive electrode may be made of a plurality of types. Selection may be performed based on an actual requirement, to implement good performance of the component through a simple process.

According to a second aspect of embodiments of this application, a manufacturing method of a solar cell component is provided, including:
forming a first electrode, a light absorption layer, and a second electrode on a substrate, where the first electrode includes a first conductive electrode, and the second electrode includes a second conductive electrode;
the light absorption layer is located between the first conductive electrode and the second conductive electrode; and
the first electrode further includes a first bus electrode, the first bus electrode is connected to a periphery of the first conductive electrode, and a sheet resistance of the first bus electrode is less than a sheet resistance of the first conductive electrode.

In some possible implementations, the second electrode further includes a second bus electrode, the second bus electrode is connected to a periphery of the second conductive electrode, and a sheet resistance of the second bus electrode is less than a sheet resistance of the second conductive electrode.

In some possible implementations, the second bus electrode and the second conductive electrode are located on a same side of the light absorption layer, and the second bus electrode and the second conductive electrode are located on the other side of the light absorption layer.

In some possible implementations, the light absorption layer is further located between the first bus electrode and the second bus electrode.

In some possible implementations, the first conductive electrode is in contact with the substrate, the second conductive electrode is far away from the substrate, the second conductive electrode includes a second conductive grid, and the second conductive grid is configured to enhance a conductivity of the second conductive electrode; and the forming a first electrode, a light absorption layer, and a second electrode on a substrate includes:
forming the first electrode on the substrate;
forming the light absorption layer on the first electrode; and
forming the second electrode on the light absorption layer.

In some possible implementations, the second conductive electrode further includes a second conductive modification layer, and the second conductive modification layer is located on a side that is of the second conductive grid and that faces the light absorption layer, and is configured to increase flatness of a contact surface between the second conductive electrode and the light absorption layer.

In some possible implementations, the second conductive modification layer is made of at least one of the following types: a transparent conductive oxide, a metal nanowire, a conductive polymer, a carbon-based material, and a thin-film metal.

In some possible implementations, before the second conductive grid is formed, the method further includes:
forming a first conductive adhesive on the light absorption layer, to increase conductivity efficiency between the second conductive grid and the light absorption layer.

In some possible implementations, the first bus electrode, the second bus electrode, and the first conductive electrode are located on a same side of the light absorption layer, the second conductive electrode is located on the other side of the light absorption layer, and the second conductive electrode is electrically connected to the second bus electrode through an interconnection structure.

In some possible implementations, the second conductive electrode is parallel to the first conductive electrode, and the interconnection structure extends from the periphery of the second conductive electrode to the first conductive electrode, and is connected to the second bus electrode located on the periphery of the first conductive electrode.

In some possible implementations, both the first bus electrode and the second bus electrode are in contact with the substrate; the first bus electrode includes a third conductive grid, and the second bus electrode includes a fourth conductive grid; and the forming a first electrode, a light absorption layer, and a second electrode on a substrate includes:
forming, on the substrate, the first conductive electrode, the first bus electrode, and the second bus electrode on a periphery of the first bus electrode;
forming the light absorption layer on the first conductive electrode and the first bus electrode; and
forming the second conductive electrode on the light absorption layer, and forming, on the periphery of the second conductive electrode, the interconnection structure that electrically connects the second conductive electrode and the second bus electrode.

In some possible implementations, the first conductive electrode includes a first conductive grid; or
the first conductive electrode includes a first conductive grid and a first conductive modification layer located on a side that is of the first conductive grid and that faces the light absorption layer.

In some possible implementations, the first conductive modification layer is made of at least one of the following types: a transparent conductive oxide, a metal nanowire, a conductive polymer, a carbon-based material, and a thin-film metal.

In some possible implementations, the method further includes:
forming a first carrier transport layer between the first electrode and the light absorption layer, and forming a second carrier transport layer between the second electrode and the light absorption layer.

In some possible implementations, the sheet resistance of the first conductive electrode is 5 to 1000 times the sheet resistance of the first bus electrode, and the sheet resistance of the second conductive electrode is 5 to 1000 times the sheet resistance of the second bus electrode.

According to a third aspect of embodiments of this application, an electronic device is provided, including a circuit board and the solar cell component according to the first aspect of this application, where the solar cell component is connected to the circuit board.

### BRIEF DESCRIPTION OF DRAWINGS

To clearly understand specific implementations of this application, the following briefly describes accompanying drawings used for describing the specific implementations of this application. Apparently, the accompanying drawings show merely some embodiments of this application.
FIG. 1 is a schematic diagram of a structure of smart glasses including a solar cell component according to an embodiment of this application;
FIG. 2 to FIG. 7 are schematic diagrams of structures of a plurality of solar cell components according to embodiments of this application;
FIG. 8 is a flowchart of a manufacturing method of a solar cell component according to an embodiment of this application;
FIG. 9 is a flowchart of another manufacturing method of a solar cell component according to an embodiment of this application;
FIG. 10 is a flowchart of still another manufacturing method of a solar cell component according to an embodiment of this application; and
FIG. 11 to FIG. 14 are schematic diagrams of a component structure in a manufacturing process of a solar cell component according to an embodiment of this application.

### DESCRIPTION OF EMBODIMENTS

Embodiments of this application provide a solar cell component, a manufacturing method thereof, and an electronic device, to improve optical-to-electrical conversion efficiency of the component.

In the specification, claims, and accompanying drawings of this application, the terms "first", "second", "third", "fourth", and the like (if exist) are intended to distinguish between similar objects but do not necessarily indicate a specific order or sequence. It should be understood that the data termed in such a way are interchangeable in appropriate circumstances, so that embodiments described herein can be implemented in an order other than the order illustrated or described herein. In addition, the terms "include" and "contain" and any other variants mean to cover the non-exclusive inclusion, for example, a process, method, system, product, or device that includes a series of steps or units is not necessarily limited to those steps or units, but may include other steps or units not expressly listed or inherent to such a process, method, product, or device.

This application is described in detail with reference to the schematic diagrams. When embodiments of this application are described in detail, for ease of description, a sectional view illustrating a component structure is not partially enlarged according to a general proportion. In addition, the schematic diagrams are merely examples and should not limit the protection scope of this application herein. In addition, the length, width, and depth of the three-dimensional space should be included in actual production.

In a large-area solar cell component, an area of an electrode is also large, and a sheet resistance of the electrode has obvious impact on optical-to-electrical conversion efficiency of the component. Therefore, reducing the sheet resistance of the electrode facilitates charge collection of the component, and improves efficiency of the solar cell component. In addition, because the area of the electrode is large, a sheet resistance loss of the electrode is prone to being generated by long-distance migration of a charge in the electrode, affecting efficiency of the solar cell component.

Based on the foregoing technical problem, embodiments of this application provide a solar cell component, a manufacturing method thereof, and an electronic device. The solar cell component may include a first electrode, a second electrode, and a light absorption layer. The first electrode includes a first conductive electrode, and the second electrode includes a second conductive electrode. The light absorption layer is located between the first conductive electrode and the second conductive electrode. The first electrode further includes a first bus electrode. The first bus electrode is connected to a periphery of the first conductive electrode, and a sheet resistance of the first bus electrode is less than a sheet resistance of the first conductive electrode. The first bus electrode is electrically connected to the first conductive electrode. In other words, a sheet resistance of a peripheral region of the first electrode is less than a sheet resistance of a central region of the first electrode. In this way, compared with a case in which a first electrode includes only a single first conductive electrode, a sheet resistance of the first electrode is reduced. After an optical charge is transmitted to the first conductive electrode, the optical charge can be quickly converged to the periphery, thereby reducing a sheet resistance loss caused by long-distance uneven transmission of the optical charge, and facilitating collection of the optical charge. Therefore, optical-to-electrical conversion efficiency of the solar cell component can be improved.

The solar cell component provided in embodiments of this application has high performance, and may be used in an intelligent device. For example, the solar cell component may be used in a lens, a display, or a transparent housing of an intelligent wearable device such as smart glasses, smart goggles, AR/VR, a smart watch/band, or a head-mounted headset, or may be used in a display, a transparent housing, or the like of an intelligent consumer electronic device such as a mobile phone, a tablet computer, or a notebook computer, or may be used in another scenario application such as a vehicle, a building, or internet of things.

To make the objectives, features, and advantages of this application more apparent and understandable, the following describes specific implementations of this application in detail with reference to the accompanying drawings.

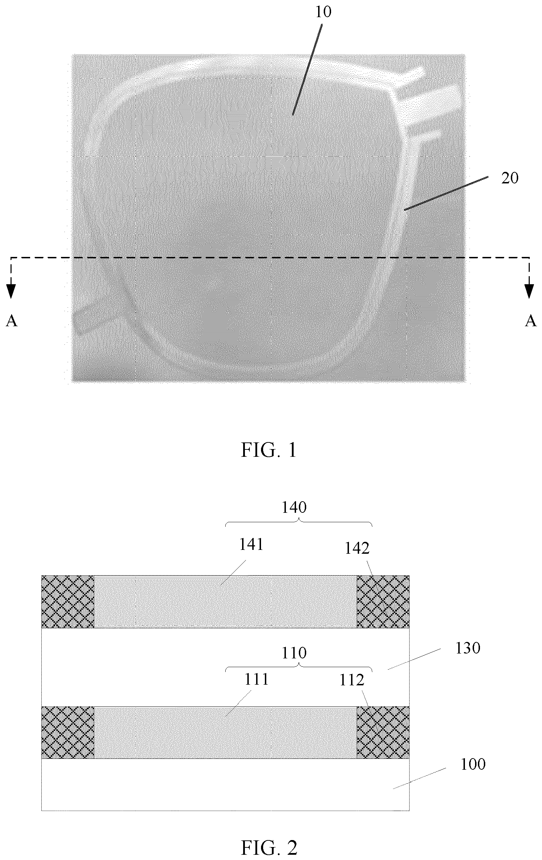

FIG. 1 is a schematic diagram of smart glasses including a solar cell component. A shape of the solar cell component is consistent with a shape of the smart glasses. The smart glasses may include a lens region 10 and a lens frame region 20. The lens region 10 may be made of a transparent material or a semitransparent material. The lens frame region 20 may be made of a semitransparent material or an opaque material. The lens frame region 20 may completely surround the lens region 10 to form smart glasses with a full lens frame. Alternatively, the lens frame region 20 may partially surround the lens region 10 to form smart glasses with a half lens frame. An area of the lens frame region 20 is smaller than an area of the lens region 10.

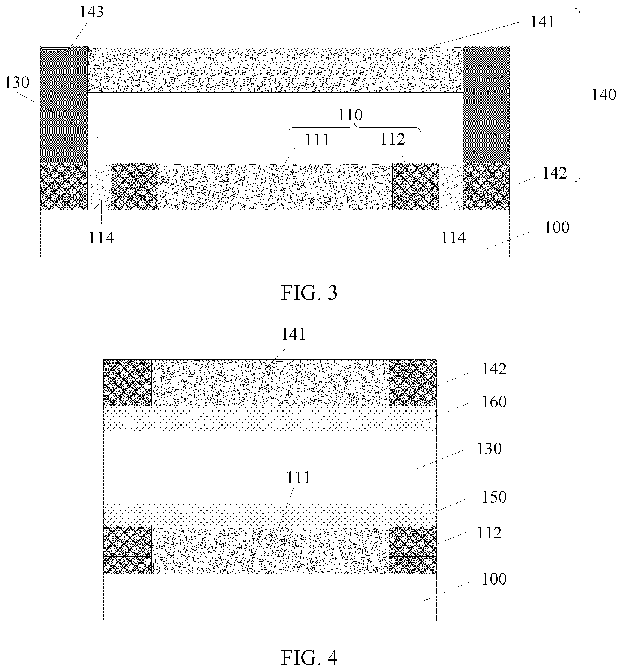

FIG. 2 and FIG. 3 are schematic diagrams of structures of two solar cell components according to embodiments of this application. When the shape of the solar cell components is consistent with the shape of the smart glasses, the solar cell components in FIG. 2 and FIG. 3 may be sectional views of the smart glasses in FIG. 1 along an AA direction. Specifically, the solar cell component may include a first electrode 110, a second electrode 140, and a light absorption layer 130. The first electrode 110 includes a first conductive electrode 111, and the second electrode 140 includes a second conductive electrode 141. The light absorption layer 130 is located between the first conductive electrode 111 and the second conductive electrode 141. After absorbing photons, the light absorption layer 130 is excited to generate an electron-hole pair. Electrons and holes may be respectively transmitted to the first conductive electrode 111 and the second conductive electrode 141 as photogenerated carriers, thereby implementing external power supply.

One of the first conductive electrode 111 and the second conductive electrode 141 is a bottom electrode. The bottom electrode is an electrode disposed close to a substrate 100, and is also an electrode formed before the light absorption layer 130. The bottom electrode may be an electrode in contact with the substrate 100. The other one of the first conductive electrode 111 and the second conductive electrode 141 is a top electrode. The top electrode is an electrode disposed far away from the substrate 100, and is also an electrode formed after the light absorption layer 130. The substrate 100 may be a transparent substrate. In this case, one side of the bottom electrode may be a light receiving side, and one side of the top electrode may also be a light receiving side. The substrate 100 may alternatively be a non-transparent substrate. In this case, one side of the top electrode is a light receiving side. When the first conductive electrode 111 is a bottom electrode and the second conductive electrode 141 is a top electrode, the first conductive electrode 111, the light absorption layer 130, and the second conductive electrode 141 may be sequentially disposed from the substrate 100. When the first conductive electrode 111 is a top electrode and the second conductive electrode 141 is a bottom electrode, the second conductive electrode 141, the light absorption layer 130, and the first conductive electrode 111 may be sequentially disposed from the substrate 100.

Shapes of the first conductive electrode 111 and the second conductive electrode 141 may be set based on a shape of the substrate 100. The shape of the substrate 100 may be determined based on an application scenario of the solar cell component. For example, the substrate 100 may be in a regular shape such as a circle or a rectangle, or may be in an irregular shape such as a glasses lens, a watch display, or a band display. Specifically, the first conductive electrode 111 and the second conductive electrode 141 may be disposed in the lens region 10 in FIG. 1. When the lens region 10 is made of a transparent material, the first conductive electrode 111 and the second conductive electrode 141 are made of a transparent material. When the lens region 10 is made of a semitransparent material, the first conductive electrode 111 and the second conductive electrode 141 may be made of a transparent material or a semitransparent material.

In this embodiment of this application, the first electrode 110 may further include a first bus electrode 112. The first bus electrode 112 is connected to a periphery of the first conductive electrode 111, and a sheet resistance of the first bus electrode 112 is less than a sheet resistance of the first conductive electrode 111. In other words, a sheet resistance of a peripheral region of the first electrode 110 is less than a sheet resistance of a central region of the first electrode 110. In this way, compared with a case in which a first electrode 110 includes a single first conductive electrode 111, an overall sheet resistance of the first electrode 110 is reduced. In this structure, if an optical charge is conducted to the first conductive electrode 111, the optical charge tends to be converged and conducted to the first bus electrode 112 with a small sheet resistance. That is, this structure facilitates transfer of the optical charge to the periphery, thereby reducing long-distance uneven migration of the optical charge in the first conductive electrode 111, and reducing a sheet resistance loss caused by the long-distance uneven migration of the optical charge. The sheet resistance is a square resistance, and is a resistance per unit area of a thin-film conductive material. The resistance per unit area is a resistance between edges of a thin-film conductive material per square unit area.

In this embodiment of this application, the second electrode 140 may further include a second bus electrode 142. The second bus electrode 142 is connected to a periphery of the second conductive electrode 141, and a sheet resistance of the second bus electrode 142 is less than a sheet resistance of the second conductive electrode 141. In other words, a sheet resistance of a peripheral region of the second electrode 140 is less than a sheet resistance of a central region of the second electrode 140. In this way, compared with a case in which a second electrode 140 includes a single second conductive electrode 141, an overall sheet resistance of the second electrode 140 is reduced. In this structure, if an optical charge is conducted to the second conductive electrode 141, the optical charge tends to be converged and conducted to the second bus electrode 142 with a small sheet resistance. That is, this structure facilitates transfer of the optical charge to the periphery, thereby reducing long-distance migration of the optical charge in the second conductive electrode 141, and reducing a sheet resistance loss caused by the long-distance migration of the optical charge.

It should be noted that the structure in which the sheet resistance of the peripheral region of the first electrode 110 is less than the sheet resistance of the central region of the first electrode 110 is an improvement on the first electrode 110, and the structure in which the sheet resistance of the peripheral region of the second electrode 140 is less than the sheet resistance of the central region of the second electrode 140 is an improvement on the second electrode 140. In this embodiment of this application, only the first electrode 110 may be improved, that is, only the electrode on one side may be improved, or both the first electrode 110 and the second electrode 140 may be improved. Compared with a case in which the first electrode 110 and the second electrode 140 each are a single electrode, efficiency of a solar cell is improved. When only the first electrode 110 is improved, the second electrode 140 includes only the second conductive electrode 141.

Specifically, the first bus electrode 112 is disposed on a periphery of a region in which the first conductive electrode 111 is located. The first bus electrode 112 may be disposed on the periphery of the first conductive electrode 111 along an outer edge of the first conductive electrode 111. Specifically, the first bus electrode 112 may completely surround the first conductive electrode 111 by one circle around the first conductive electrode 111 to form a closed ring, or may be disposed on a part of an outer edge of the periphery of the first conductive electrode 111 to form an arc line, a straight line, a broken line, or an incompletely closed ring. For example, the foregoing solar cell component is used in the smart glasses. When the first conductive electrode 111 is in a lens shape and disposed in the lens region 10, the first bus electrode 112 may form a lens frame shape and be disposed in the lens frame region 20. The first bus electrode 112 may be disposed around the first conductive electrode 111 and completely surround the first conductive electrode 111, to have a same shape and area as the lens frame region 20. The first bus electrode 112 may alternatively be disposed on a part of an outer position of the first conductive electrode 111 based on the lens frame shape, to be located on a part of the lens frame region 20. Compared with the first conductive electrode 111, the first bus electrode 112 has a smaller area, and a width range of the first bus electrode 112 may be 0.1 mm to 5 mm.

Similarly, the second bus electrode 142 is disposed on a periphery of a region in which the second conductive electrode 141 is located, and the second bus electrode 112 may be disposed on the periphery of the second conductive electrode 141 along an outer edge of the second conductive electrode 141. Specifically, the second bus electrode 142 may completely surround the second conductive electrode 141 by one circle around the second conductive electrode 141 to form a closed ring, or may be disposed on a part of an outer edge of the periphery of the second conductive electrode 141 to form an arc line, a straight line, a broken line, or an incompletely closed ring. For example, the foregoing solar cell component is used in the smart glasses. When the second conductive electrode 141 is in the lens shape and disposed in the lens region 10, the second bus electrode 142 may form the lens frame shape and be disposed in the lens frame region 20. The second bus electrode 142 may be disposed around the second conductive electrode 141 and completely surround the second conductive electrode 141, to have a same shape and area as the lens frame region 20. The second bus electrode 142 may alternatively be disposed on a part of an outer position of the second conductive electrode 141 based on the lens frame shape, to be located on a part of the lens frame region 20. Compared with the second conductive electrode 141, the second bus electrode 142 has a smaller area, and a width of the second bus electrode 142 may be 0.1 mm to 5 mm. In other words, the first bus electrode 112 and the second bus electrode 142 are disposed at an edge position of the component, have small sizes, and are similar to a frame with a high conductivity.

In this embodiment of this application, the first conductive electrode 111 may include at least one of the following structures: a thin metal, a transparent conductive oxide (TCO), a metal nanowire, a conductive polymer, a carbon-based material, and a conductive grid. The second conductive electrode 141 may include at least one of the following structures: a thin metal, a TCO, a metal nanowire, a conductive polymer, a carbon-based material, and a conductive grid. The first conductive electrode 111 and the second conductive electrode 141 may have a same structure or different structures, and may be made of a same material or different materials. The transparent conductive oxide may include indium tin oxide (ITO), indium zinc oxide (IZO), fluorine-doped tin oxide (FTO), or the like. The metal in the thin metal may be a single material, or may be an alloy of multiple metals, such as one or more of silver, copper, nickel, and gold. The carbon-based material may include graphite, graphene, a carbon nanotube, or the like. A shape of the conductive grid may be a polygon or a random grid. The polygon may include a square, a hexagon, a diamond, or the like. A material of the conductive grid may include metal and/or a conductive polymer. Optionally, the metal may include a combination of one or more of silver, copper, nickel, gold, and the like. For example, a material of a metal grid is silver or copper.

In this embodiment of this application, the first bus electrode 112 may have at least one of the following structures: a thin metal, a metal nanowire, a conductive polymer, graphene, a carbon nanotube, and a conductive grid. The second bus electrode 142 may have at least one of the following structures: a thin metal, a metal nanowire, a conductive polymer, graphene, a carbon nanotube, and a conductive grid. The first bus electrode 112 and the second bus electrode 142 may have a same structure or different structures, and may be made of a same material or different materials. The transparent conductive oxide may include ITO, IZO, FTO, or the like. The metal in the thin metal may be a single material, or may be an alloy of multiple metals, such as one or more of silver, copper, nickel, and gold. A shape of the conductive grid may be a polygon or a random grid. The polygon may include a square, a hexagon, a diamond, or the like. A material of the conductive grid may include metal and/or a conductive polymer. Optionally, the metal may include a combination of one or more of silver, copper, nickel, gold, and the like. For example, a material of a metal grid is silver and copper.

The sheet resistance of the first conductive electrode 111 may be 5 to 1000 times the sheet resistance of the first bus electrode 112. The first conductive electrode 111 and the first bus electrode 112 may have a same structure, and may, for example, each include a conductive grid. The first conductive electrode 111 and the first bus electrode 112 may alternatively have different structures. For example, the first conductive electrode 111 includes a transparent conductive oxide, and the first bus electrode 112 includes a conductive grid. When the first conductive electrode 111 and the first bus electrode 112 have a same structure, the first conductive electrode 111 and the first bus electrode 112 may be made of a same material or different materials. When a type and a material of the first conductive electrode 111 are the same as those of the first bus electrode 112, the first bus electrode 112 has a larger thickness or density than the first conductive electrode 111. For example, the first bus electrode 112 and the first conductive electrode 111 each are made of a transparent conductive oxide, and the first bus electrode 112 has a larger thickness. Alternatively, the first bus electrode 112 and the first conductive electrode 111 each are a grid made of aluminum, and the grid of the first bus electrode 112 has a higher density.

The sheet resistance of the second conductive electrode 141 may be 5 to 1000 times the sheet resistance of the second bus electrode 142. The second conductive electrode 141 and the second bus electrode 142 may have a same structure, and may, for example, each include a conductive grid. The second conductive electrode 141 and the second bus electrode 142 may alternatively have different structures. For example, the second conductive electrode 141 includes a thin metal, and the second bus electrode 142 includes a conductive grid. When the second conductive electrode 141 and the second bus electrode 142 have a same structure, the second conductive electrode 141 and the second bus electrode 142 may be made of a same material or different materials. When a type and a material of the second conductive electrode 141 are the same as those of the second bus electrode 142, the second bus electrode 142 has a larger thickness and/or density than the second conductive electrode 141. For example, when the second bus electrode 142 and the second conductive electrode 141 each are made of a thin metal, the second bus electrode 142 has a larger thickness. Alternatively, the second bus electrode 142 and the second conductive electrode 141 each are a grid made of aluminum, and the grid of the second bus electrode 142 has a higher density.

In this embodiment of this application, the light absorption layer 130 may be an organic layer, a perovskite layer, a quantum dot layer, or the like. An organic light absorption layer 130 includes a two-element or multi-element blended film of at least one electron donor material and at least one electron acceptor material. The electron donor material may be at least one of polymers PTB7-Th, PBDB-T, PM6, and D 18, and derivatives. The electron acceptor material may be at least one of materials PCBM, ITIC, and Y6, and derivatives. When the light absorption layer 130 is the perovskite layer, a material may include one or more of methylammonium lead iodide, formamidinium lead iodide, cesium lead iodine, and three-dimensional and two-dimensional perovskites with multiple composite cations and composite anions. When the light absorption layer 130 is the quantum dot layer, the material may include the foregoing perovskite quantum dots, lead sulfide (selenide), cadmium sulfide, indium phosphide, and the like. For example, a material of the light absorption layer 130 is P3HT:PC₆₁BM.

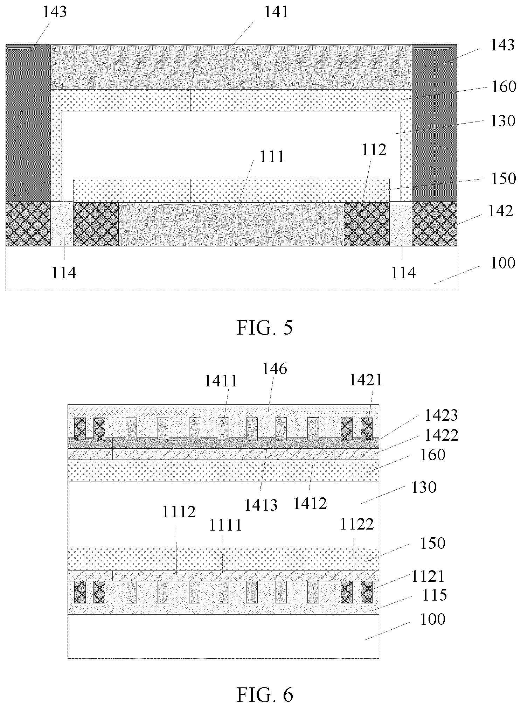

In this embodiment of this application, a first carrier transport layer 150 may be further disposed between the first conductive electrode 111 and the light absorption layer 130, and a second carrier transport layer 160 may be further disposed between the second conductive electrode 141 and the light absorption layer 130. FIG. 4 and FIG. 5 are schematic diagrams of structures of solar cell components according to embodiments of this application. One of the first carrier transport layer 150 and the second carrier transport layer 160 is an electron transport layer, and the other one is a hole transport layer. In other words, after generating the electron-hole pair, the light absorption layer 130 transmits electrons to the first electrode 110 or the second electrode 140 through the electron transport layer, and transmits holes to the second electrode 140 or the first electrode 110 through the hole transport layer. The electron transport layer includes n-type metal oxides, conjugate and non-conjugate polymers, or small molecules, such as PFN, PDINO, or PEI, and derivatives, or zinc oxide (ZnO) or titanium oxide (TiO₂). The hole transport layer includes p-type metal oxides, conjugate and non-conjugate polymers, or small molecules, such as PEDOT:PSS, PTAA, or spiro-OMeTAD, or molybdenum oxide (MoOs) or nickel oxide (NiOₓ). A thickness range of the electron transport layer may be 30 nm to 100 nm, and a thickness range of the hole transport layer may be 10 nm to 50 nm.

Specifically, when the first conductive electrode 111 is used as the bottom electrode, the first conductive electrode 111, the light absorption layer 130, and the second conductive electrode 141 may be sequentially formed upward from the substrate 100. When the solar cell component includes the first carrier transport layer 150 and the second carrier transport layer 160, the first conductive electrode 111, the first carrier transport layer 150, the light absorption layer 130, the second carrier transport layer 160, and the second conductive electrode 141 may be sequentially formed upward from the substrate 100. The light absorption layer 130 needs to receive light. For example, light may be irradiated to the light absorption layer 130 through the first conductive electrode 111 and the first carrier transport layer 150, or may be irradiated to the light absorption layer 130 through the second conductive electrode 141 and the second carrier transport layer 160. Therefore, at least one of the first conductive electrode 111 and the second conductive electrode 141 is a transparent electrode, to ensure smooth passing of light, and the electrode on the side through which light does not need to be transmitted may be set as a transparent electrode or a semitransparent electrode.

In this embodiment of this application, as shown in FIG. 2 and FIG. 4, the first bus electrode 112 and the first conductive electrode 111 may be located on a same side of the light absorption layer 130, and the second bus electrode 142 and the second conductive electrode 141 may be located on the other side of the light absorption layer 130. In this way, the first electrode 110 is located on one side of the light absorption layer 130, and the second electrode 140 is located on the other side of the light absorption layer 130. The first conductive electrode 111 and the second conductive electrode 141 are disposed opposite to each other. The first bus electrode 112 and the second bus electrode 142 may also be disposed opposite to each other. The light absorption layer 130 may be further located between the first bus electrode 112 and the second bus electrode 142. Carriers generated in the light absorption layer 130 located between the first bus electrode 112 and the second bus electrode 142 may be directly transmitted to the first bus electrode 112 and the second bus electrode 142, and do not need to be transmitted to the first bus electrode 112 through the first conductive electrode 111 or transmitted to the second bus electrode 142 through the second conductive electrode 141, thereby shortening a transmission path, reducing a transmission loss, and improving carrier collection efficiency.

The following uses an example in which the first conductive electrode 111 is the bottom electrode and the second conductive electrode 141 is the top electrode for description. The second conductive electrode 141 may include a conductive grid, and therefore has a high conductivity. Certainly, the second bus electrode 142 may also include a conductive grid. The second bus electrode 142 and the second conductive electrode 141 are disposed on a same side of the light absorption layer 130. The conductive grid of the second conductive electrode 141 and the conductive grid of the second bus electrode 142 may be formed through a same process, and no additional process is required. FIG. 6 is a schematic diagram of a structure of still another solar cell component according to an embodiment of this application. The second conductive electrode 141 may include a conductive grid. Alternatively, the second conductive electrode 141 includes a thin metal, and the second bus electrode 142 includes a conductive grid, so that the second electrode 140 is compatible with a conventional process and has a high conductivity.

Specifically, the second conductive electrode 141 may be made of a thin metal, or may include a second conductive grid 1411. The conductive grid has a high conductivity and light transmission, and a transparent metal grid based on a nano-imprinting technology also has excellent light transmission and conductivity. Therefore, the second conductive grid 1411 may have both a conductivity and light transmission. Compared with a case in which the second conductive electrode 141 is made of a thin metal obtained through thermal evaporation, when the second conductive electrode 141 includes the second conductive grid 1411, the second conductive electrode 141 has a higher conductivity. This facilitates improving charge collection efficiency. The second conductive grid 1411 may be embedded into a transparent colloidal layer 146, to facilitate fastening of the second conductive grid 1411, as shown in FIG. 6. The transparent colloidal layer 146 may be made of a colloidal material formed after liquid curing, and includes but is not limited to a thermoplastic polymer, a photocuring polymer, a thermocuring polymer, or the like.

When the second conductive electrode 141 includes the second conductive grid 1411, the second conductive electrode 141 may further include a second conductive modification layer 1412. The second conductive grid 1411 and the second conductive modification layer 1412 form a composite electrode. The second conductive modification layer 1412 is located on a side that is of the second conductive grid 1411 and that faces the light absorption layer 130. When the second conductive electrode 141 is the top electrode, the second conductive modification layer 1412 is located below the second conductive grid 1411, to reduce a step and surface roughness between grid wires of the second conductive grid 1411 and the transparent colloidal layer 146, and increase flatness of a surface that is of the second conductive electrode 141 and that faces the light absorption layer 130, so that the second conductive electrode 141 has a flat surface to be in contact with a film layer below. A material of the second conductive modification layer 1412 may be at least one of a transparent conductive oxide, a metal nanowire, a conductive polymer, a carbon-based material, a thin metal layer, or the like. The conductive polymer can improve wettability of an active layer, and is conducive to forming a film on the active layer. However, the conductive polymer may not have a conductivity and light transmission at the same time, and the carbon-based material such as a carbon nanotube and graphene, and a metal nanowire may not have a conductivity and light transmission at the same time.

For example, the second conductive modification layer 1412 may be made of a transparent conductive oxide, and is disposed on a surface of a transparent conductive grid and electrically connected to the transparent conductive grid. The transparent conductive oxide may be at least one of ITO, IZO, FTO, or the like. The transparent conductive oxide has good light transmission. This facilitates light absorption by the light absorption layer 130. In addition, a work function of the transparent conductive oxide is close to a work function of an interface of the component. This does not affect interface charge collection, and facilitates obtaining a component with higher performance. A thickness range of the transparent conductive oxide may be 5 nm to 100 nm. Alight transmittance of the composite electrode based on the transparent conductive oxide is 50% to 98%, and a sheet resistance may be 0.01 to 20 S2/o.

When the second conductive electrode 141 includes the second conductive grid 1411, the solar cell component may further include a first conductive adhesive 1413. The first conductive adhesive 1413 is located on a side that is of the second conductive grid 1411 and that faces the light absorption layer 130, that is, located between the second conductive grid 1411 and the light absorption layer 130, to increase conductivity efficiency between the second conductive grid 1411 and the light absorption layer 130. When the second conductive electrode 141 includes the second conductive modification layer 1412, the second conductive modification layer 1412 may be located on a side that is of the first conductive adhesive 1413 and that faces the second conductive grid 1411, or may be located on a side that is of the first conductive adhesive 1413 and that faces the light absorption layer 130. When the second conductive electrode 141 is the top electrode, the first conductive adhesive 1413 is disposed under the second conductive grid 1411, and the first conductive adhesive 1413 is a material layer that ensures close mechanical contact and electrical contact. A material of the first conductive adhesive 1413 may be a PEDOT:PSS doped with D-sorbitol (D-sorbitol, alias sorbitol), or the like.

Specifically, the second bus electrode 142 may include a fourth conductive grid 1421. A density of the fourth conductive grid 1421 of the second bus electrode 142 is greater than a density of the second conductive grid 1411 of the second conductive electrode 141, to have a larger conductive area; and/or a thickness of the fourth conductive grid 1421 of the second bus electrode 142 is greater than a thickness of the second conductive grid 1411 of the second conductive electrode 141, to have a larger depth-width ratio, so that the sheet resistance of the second bus electrode 142 is less than the sheet resistance of the second conductive electrode 141. A thickness of the conductive grid is a size perpendicular to a surface of the substrate 100, a depth is a size perpendicular to the surface of the substrate 100, and a width is a size parallel to the surface of the substrate 100. The fourth conductive grid 1421 may also be embedded into the transparent colloidal layer 146.

The second bus electrode 142 may further include a fourth conductive modification layer 1422. The fourth conductive modification layer 1422 is located on a side that is of the fourth conductive grid 1421 and that faces the light absorption layer 130. The solar cell component may further include a second conductive adhesive 1423. The second conductive adhesive 1423 is located on a side that is of the fourth conductive grid 1421 and that faces the light absorption layer 130, as shown in FIG. 6. The second conductive modification layer 1412 and the fourth conductive modification layer 1422 may be made of a same material, and may be simultaneously formed. The first conductive adhesive 1413 and the second conductive adhesive 1423 may be made of a same material, and may be simultaneously formed.

Specifically, the first conductive electrode 111 may include a first conductive grid 1111, as shown in FIG. 6. The conductive grid has a high conductivity and light transmission, and a transparent metal grid based on the nano-imprinting technology also has excellent light transmission and conductivity. Therefore, the first conductive grid 1111 may have both a conductivity and light transmission. The first conductive grid 1111 may be embedded into a transparent colloidal layer 115, to facilitate fastening of the first conductive grid 1111. The transparent colloidal layer 115 may be made of a colloidal material formed after liquid curing, and includes but is not limited to a thermoplastic polymer, a photocuring polymer, a thermocuring polymer, or the like.

The first conductive electrode 111 may further include a first conductive modification layer 1112. The first conductive grid 1111 and the first conductive modification layer 1112 form a composite electrode. The first conductive modification layer 1112 is located on a side that is of the first conductive grid 1111 and that faces the light absorption layer 130. When the first conductive electrode 111 is the bottom electrode, the first conductive modification layer 1112 may be disposed on the first conductive grid 1111, to reduce a step and surface roughness between grid wires of the first conductive grid 1111 and the transparent colloidal layer 115, so that a flat film layer is formed on the first conductive electrode 111. A material of the first conductive modification layer 1112 may be at least one of a transparent conductive oxide, a metal nanowire, a conductive polymer, a carbon-based material, a thin metal, or the like. The conductive polymer can improve wettability of an active layer, and is conducive to forming a film on the active layer. However, the conductive polymer may not have a conductivity and light transmission at the same time, and the carbon-based material such as a carbon nanotube and graphene, and a metal nanowire may not have a conductivity and light transmission at the same time.

Specifically, the first bus electrode 112 may include a third conductive grid 1121. A density of the third conductive grid 1121 of the first bus electrode 112 is greater than a density of the first conductive grid 1111 of the first conductive electrode 111, to have a larger conductive area; and/or a thickness of the third conductive grid 1121 of the first bus electrode 112 is greater than a thickness of the first conductive grid 1111 of the first conductive electrode 111, to have a larger depth-width ratio, so that the sheet resistance of the first bus electrode 112 is less than the sheet resistance of the first conductive electrode 111. A thickness of the conductive grid is a size perpendicular to the surface of the substrate 100, a depth is a size perpendicular to the surface of the substrate 100, and a width is a size parallel to the surface of the substrate 100. The third conductive grid 1121 may also be embedded into the transparent colloidal layer 115. The first bus electrode 112 may further include a third conductive modification layer 1122. The third conductive modification layer 1122 is located on a side that is of the third conductive grid 1121 and that faces the light absorption layer 130, as shown in FIG. 6. The third conductive modification layer 1122 and the first conductive modification layer 1112 may be made of a same material, and may be simultaneously formed.

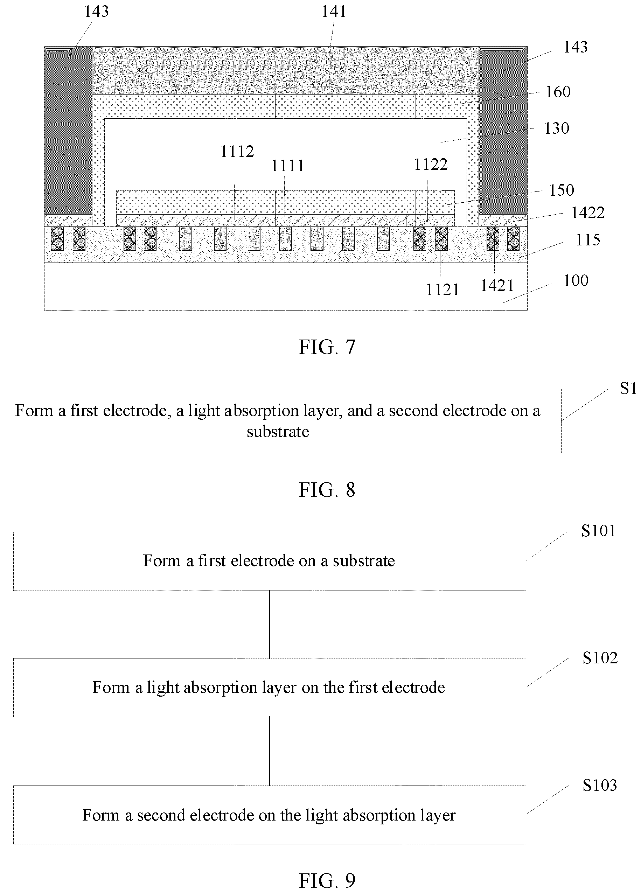

In this embodiment of this application, as shown in FIG. 3, FIG. 5, and FIG. 7, FIG. 7 is a schematic diagram of a structure of still another solar cell component according to an embodiment of this application. The first bus electrode 112, the second bus electrode 142, and the first conductive electrode 111 may be located on a same side of the light absorption layer 130, and the second conductive electrode 141 is located on the other side of the light absorption layer 130. The second conductive electrode 141 is electrically connected to the second bus electrode 142 through an interconnection structure. In this way, the first bus electrode 112 and the second bus electrode 142 may be formed through a same process. Compared with a conventional technology in which a first electrode 110 includes a first conductive electrode 111 and a second electrode 140 includes a second conductive electrode 141, only one process needs to be added to form both the first bus electrode 112 and the second bus electrode 142 in this embodiment of this application, thereby simplifying the process and reducing costs. The first carrier transport layer 150, the light absorption layer 130, and the second carrier transport layer 160 may be film layers sequentially stacked upward on the substrate, or may be set as film layers sequentially stacked from inside to outside. For example, the light absorption layer 130 covers a side wall and an upper surface of the first carrier transport layer 150, and the second carrier transport layer 160 covers a side wall and an upper surface of the light absorption layer, as shown in FIG. 5 and FIG. 7. In this case, the second carrier transport layer 160 is disposed between the light absorption layer 130 and an interconnection structure 143.

The first bus electrode 112, the second bus electrode 142, and the first conductive electrode 111 are located on the same side of the light absorption layer 130, the first bus electrode 112 is located on the periphery of the first conductive electrode 111, and the second bus electrode 142 is located on the periphery of the second conductive electrode 141. To facilitate electrical connection between the first bus electrode 112 and the first conductive electrode 111, the second bus electrode 142 may be disposed on a periphery of the first bus electrode 112, and the second bus electrode 142 may partially or completely surround the first bus electrode 112. The first bus electrode 112 and the second bus electrode 142 are not electrically connected. A specific distance needs to be set between the first bus electrode 112 and the second bus electrode 142, to prevent a short circuit between the first electrode 110 and the second electrode 140. Specifically, a distance range between the first bus electrode 112 and the second bus electrode 142 is not limited to 0.1 mm to 10 mm. An isolation structure 114 may be disposed between the first bus electrode 112 and the second bus electrode 142. The isolation structure may be a transparent colloidal layer 115, or may be the light absorption layer 130, or may be a laminated layer of multiple layers of the first carrier transport layer 150, the light absorption layer 130, and the second carrier transport layer 160.

As shown in FIG. 3, FIG. 5, and FIG. 7, the first conductive electrode 111 and the second conductive electrode 141 may be disposed in parallel, and both are located in a plane parallel to the surface of the substrate 100. The interconnection structure 143 extends from the periphery of the second conductive electrode 141 to the first conductive electrode 111, and is connected to the second bus electrode 142 located on the periphery of the first conductive electrode 111. A shape of the interconnection structure 143 projected on the substrate may be the same as a shape of the second bus electrode 142, and forms a closed ring, a straight line, an arc line, a broken line, or a non-closed ring. Alternatively, the interconnection structure 143 may be a plurality of columnar structures, and the plurality of columnar structures are all connected between the second conductive electrode 141 and the second bus electrode 142.

An area of the second conductive electrode 141 is greater than an area of the first conductive electrode 111. The first conductive electrode 111 and the first bus electrode 112 are disposed facing the second conductive electrode 141 in a direction perpendicular to the surface of the substrate 100. The light absorption layer 130 may be further disposed between the first bus electrode 112 and the first conductive electrode 111. Carriers generated in the light absorption layer 130 located between the first bus electrode 112 and the first conductive electrode 111 may be directly transmitted to the first bus electrode 112 and the second conductive electrode 141, and do not need to be transmitted to the first bus electrode 112 through the first conductive electrode 111, thereby shortening a transmission path, reducing a transmission loss, and improving carrier collection efficiency.

The following uses an example in which the first conductive electrode 111 is the bottom electrode and the second conductive electrode 141 is the top electrode for description. The first bus electrode 112 and the second bus electrode 142 may each include a conductive grid, and the second bus electrode 142 and the first electrode 110 are disposed on a same side of the light absorption layer 130, that is, a side close to the substrate 100. Both the first bus electrode 112 and the second bus electrode 142 are in contact with the substrate 100, as shown in FIG. 7. In this way, the first bus electrode 112 and the second bus electrode 142 may be simultaneously formed, and no additional step needs to be added to form the second bus electrode 142 after the light absorption layer 130 is formed, thereby reducing a quantity of processes.

Specifically, the first bus electrode 112 may include a third conductive grid 1121. When the first conductive electrode 111 includes a first conductive grid 1111, a density of the third conductive grid 1121 of the first bus electrode 112 is greater than a density of the first conductive grid 1111 of the first conductive electrode 111, to have a larger conductive area; and/or a thickness of the third conductive grid 1121 of the first bus electrode 112 is greater than a thickness of the first conductive grid 1111 of the first conductive electrode 111, to have a larger depth-width ratio, so that the sheet resistance of the first bus electrode 112 is less than the sheet resistance of the first conductive electrode 111. The third conductive grid 1121 may also be embedded into the transparent colloidal layer 115. The first bus electrode 112 may further include a third conductive modification layer 1122. The third conductive modification layer 1122 is located on a side that is of the third conductive grid 1121 and that faces the light absorption layer 130.

Specifically, the second bus electrode 142 may include a fourth conductive grid 1421. When the second conductive electrode 141 includes the second conductive grid 1411, a density of the fourth conductive grid 1421 of the second bus electrode 142 is greater than a density of the second conductive grid 1411 of the second conductive electrode 141, to have a larger conductive area; and/or a thickness of the fourth conductive grid 1421 of the second bus electrode 142 is greater than a thickness of the second conductive grid 1411 of the second conductive electrode 141, to have a larger depth-width ratio, so that the sheet resistance of the second bus electrode 142 is less than the sheet resistance of the second conductive electrode 141. The fourth conductive grid 1421 may also be embedded into the transparent colloidal layer 115. The second bus electrode 142 may further include a fourth conductive modification layer 1422. The fourth conductive modification layer 1422 is located on a side that is of the fourth conductive grid 1421 and that faces the light absorption layer 130. The third conductive modification layer 1122 and the fourth conductive modification layer 1422 may be made of a same material, and may be simultaneously formed.

Specifically, the second conductive electrode 141 may include the second conductive grid 1411, or may be made of a thin metal, as shown in FIG. 7. The second conductive electrode 141 made of the thin metal can be better compatible with a conventional process.

Specifically, the first conductive electrode 111 may include the first conductive grid 1111, and the first conductive electrode 111 may further include a first conductive modification layer 1112. The first conductive grid 1111 and the first conductive modification layer 1112 form a composite electrode, and the first conductive modification layer 1112 is located on a side that is of the first conductive grid 1111 and that faces the light absorption layer 130. The first conductive grid 1111 may be embedded into the transparent colloidal layer 115.

In this embodiment of this application, an anti-reflection film, another photonic crystal structure, or the like may be further included, is disposed on a side that is of the solar cell component and that is far away from the substrate 100, or disposed on a side that is of the substrate 100 and that is far away from the light absorption layer 130. The anti-reflection film is configured to increase light transmission, and the photonic crystal structure is configured to alternatively increase light transmission or reflection, to filter light that is incident to the light absorption layer 130. For example, when the first conductive electrode 111 is the bottom electrode, the anti-reflection film may cover the second electrode 140. A material of the anti-reflection film may be, for example, molybdenum oxide.

In an example, the first conductive electrode 111 is a composite electrode, a material of the first conductive grid 1111 is silver and copper, a material of the first conductive modification layer 1112 is ITO, a thickness of the ITO layer is 30 nm, a light transmittance of the formed first conductive electrode 111 is 85%, a sheet resistance is 0.3 Ω/□, and a size of the first electrode 110 is 5 cm x 5 cm. The first bus electrode 112 and the second bus electrode 142 each use a metal grid structure, and is specifically a square copper grid. An obtained sheet resistance is less than 0.01 Ω/□, a collecting region width is 2 mm, and an interval between the first bus electrode 112 and the second bus electrode 142 is 0.5 mm. The first carrier transport layer 150 is an electron transport layer, a material is ZnO, and a thickness is 30 nm. The second carrier transport layer 160 is a hole transport layer, a material is MoOs, and a thickness is 10 nm. A material of the light absorption layer 130 is PM6:Y7, and a thickness is 120 nm. The second conductive electrode 141 is an Ag electrode, and an anti-reflection film whose material is molybdenum oxide is disposed on the second conductive electrode 141, where a thickness of Ag is 10 nm, and a thickness of molybdenum oxide is 30 nm. Finally, the large-area solar cell component is prepared, and optical-to-electrical conversion efficiency is 4.92% and an average transmittance of visible light is 18%.

Embodiments of this application provide the solar cell component, including the first electrode, the second electrode, and the light absorption layer. The first electrode includes the first conductive electrode, and the second electrode includes the second conductive electrode. The light absorption layer is located between the first conductive electrode and the second conductive electrode. The first electrode further includes the first bus electrode. The first bus electrode is connected to the periphery of the first conductive electrode, and the sheet resistance of the first bus electrode is less than the sheet resistance of the first conductive electrode. The first bus electrode is electrically connected to the first conductive electrode. In other words, the sheet resistance of the peripheral region of the first electrode is less than the sheet resistance of the central region of the first electrode. In this way, compared with the case in which the first electrode includes only the single first conductive electrode, the sheet resistance of the first electrode is reduced. After the optical charge is transmitted to the first electrode, the optical charge can be quickly converged to the periphery, thereby reducing the sheet resistance loss caused by long-distance uneven transmission of the optical charge, and facilitating collection of the optical charge. Therefore, optical-to-electrical conversion efficiency of the solar cell component can be improved.

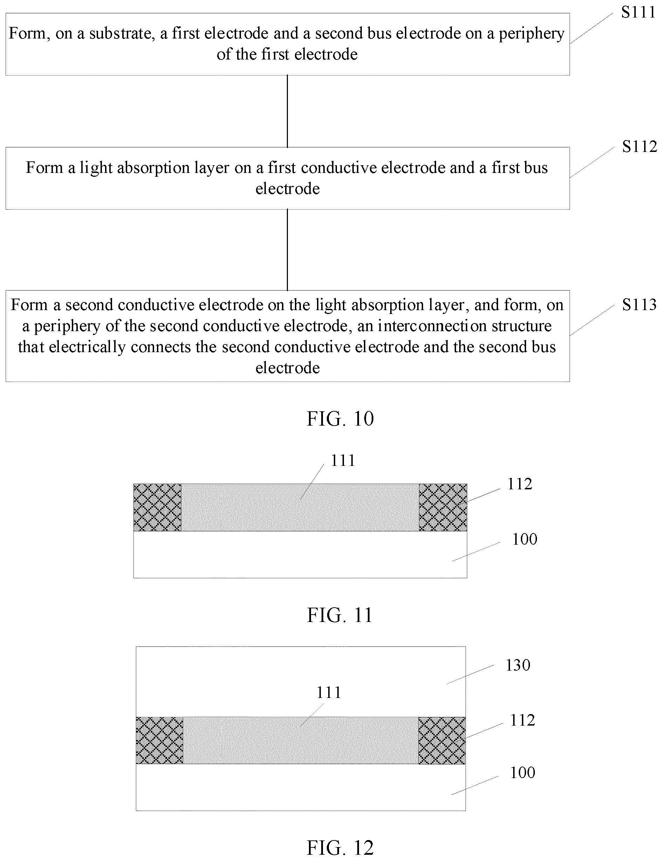

Based on the solar cell component provided in embodiments of this application, an embodiment of this application further provides a manufacturing method of a solar cell component. FIG. 8 is a flowchart of a manufacturing method of a solar cell component according to an embodiment of this application. FIG. 11 to FIG. 14 are schematic diagrams of a structure of a solar cell component in a manufacturing process. The method may include the following step.

S1: Form a first electrode 110, a light absorption layer 130, and a second electrode 140 on a substrate 100.

In this embodiment of this application, the first electrode 110, the light absorption layer 130, and the second electrode 140 may be formed on the substrate 100. The first electrode 110 includes a first conductive electrode 111, and the second electrode 140 includes a second conductive electrode 141. The light absorption layer 130 is located between the first conductive electrode 111 and the second conductive electrode 141. After absorbing photons, the light absorption layer 130 is excited to generate an electron-hole pair. Electrons and holes may be respectively transmitted to the first conductive electrode 111 and the second conductive electrode 141 as photogenerated carriers, thereby implementing external power supply.

One of the first conductive electrode 111 and the second conductive electrode 141 is a bottom electrode. The bottom electrode is an electrode disposed close to the substrate 100, and is also an electrode formed before the light absorption layer 130. The bottom electrode may be an electrode in contact with the substrate 100. The other one of the first conductive electrode 111 and the second conductive electrode 141 is a top electrode. The top electrode is an electrode disposed far away from the substrate 100, and is also an electrode formed after the light absorption layer 130. The substrate 100 may be a transparent substrate. In this case, one side of the bottom electrode may be a light receiving side, and one side of the top electrode may also be a light receiving side. The substrate 100 may alternatively be a non-transparent substrate. In this case, one side of the top electrode is a light receiving side. When the first conductive electrode 111 is a bottom electrode and the second conductive electrode 141 is a top electrode, the first conductive electrode 111, the light absorption layer 130, and the second conductive electrode 141 may be sequentially disposed from the substrate 100. When the first conductive electrode 111 is a top electrode and the second conductive electrode 141 is a bottom electrode, the second conductive electrode 141, the light absorption layer 130, and the first conductive electrode 111 may be sequentially disposed from the substrate 100.

The first electrode 110 may further include a first bus electrode 112. The first bus electrode 112 is connected to a periphery of the first conductive electrode 111, and a sheet resistance of the first bus electrode 112 is less than a sheet resistance of the first conductive electrode 111. In other words, a sheet resistance of a peripheral region of the first electrode 110 is less than a sheet resistance of a central region of the first electrode 110. The second electrode 140 may further include a second bus electrode 142. The second bus electrode 142 is connected to a periphery of the second conductive electrode 141, and a sheet resistance of the second bus electrode 142 is less than a sheet resistance of the second conductive electrode 141. In other words, a sheet resistance of a peripheral region of the second electrode 140 is less than a sheet resistance of a central region of the second electrode 140.

It should be noted that the structure in which the sheet resistance of the peripheral region of the first electrode 110 is less than the sheet resistance of the central region of the first electrode 110 is an improvement on the first electrode 110, and the structure in which the sheet resistance of the peripheral region of the second electrode 140 is less than the sheet resistance of the central region of the second electrode 140 is an improvement on the second electrode 140. In this embodiment of this application, only the first electrode 110 may be improved, that is, only the electrode on one side may be improved, or both the first electrode 110 and the second electrode 140 may be improved. Compared with a case in which the first electrode 110 and the second electrode 140 each are a single electrode, efficiency of a solar cell is improved. When only the first electrode 110 is improved, the second electrode 140 includes only the second conductive electrode 141.

Specifically, the first bus electrode 112 may be disposed on a periphery of a region in which the first conductive electrode 111 is located. The first bus electrode 112 may be disposed on the periphery of the first conductive electrode 111 along an outer edge of the first conductive electrode 111. Specifically, the first bus electrode 112 may completely surround the first conductive electrode 111 by one circle around the first conductive electrode 111 to form a closed ring, or may be disposed on a part of an outer edge of the periphery of the first conductive electrode 111 to form an arc line, a straight line, a broken line, or an incompletely closed ring. For example, the foregoing solar cell component is used in smart glasses. When the first conductive electrode 111 is in a lens shape and disposed in a lens region 10, the first bus electrode 112 may form a lens frame shape and be disposed in a lens frame region 20. Compared with the first conductive electrode 111, the first bus electrode 112 has a smaller area, and a width range of the first bus electrode 112 may be 0.1 mm to 5 mm.

Similarly, the second bus electrode 142 may be disposed on a periphery of a region in which the second conductive electrode 141 is located, and the second bus electrode 112 may be disposed on the periphery of the second conductive electrode 141 along an outer edge of the second conductive electrode 141. Specifically, the second bus electrode 142 may completely surround the second conductive electrode 141 by one circle around the second conductive electrode 141 to form a closed ring, or may be disposed on a part of an outer edge of the periphery of the second conductive electrode 141 to form an arc line, a straight line, a broken line, or an incompletely closed ring. For example, the foregoing solar cell component is used in the smart glasses. When the second conductive electrode 141 is in the lens shape and disposed in the lens region 10, the second bus electrode 142 may form the lens frame shape and be disposed in the lens frame region 20. Compared with the second conductive electrode 141, the second bus electrode 142 has a smaller area, and a width of the second bus electrode 142 may be 0.1 mm to 5 mm. In other words, the first bus electrode 112 and the second bus electrode 142 are disposed at an edge position of the component, have small sizes, and are similar to a frame with a high conductivity.

In this embodiment of this application, the first conductive electrode 111 may include at least one of the following structures: a thin metal, a TCO, a metal nanowire, a conductive polymer, a carbon-based material, and a conductive grid. The second conductive electrode 141 may include at least one of the following structures: a thin metal, a TCO, a metal nanowire, a conductive polymer, a carbon-based material, and a conductive grid. The first conductive electrode 111 and the second conductive electrode 141 may have a same structure or different structures, and may be made of a same material or different materials. In this embodiment of this application, the first bus electrode 112 may have at least one of the following structures: a thin metal, a metal nanowire, a conductive polymer, graphene, a carbon nanotube, and a conductive grid. The second bus electrode 142 may have at least one of the following structures: a thin metal, a metal nanowire, a conductive polymer, graphene, a carbon nanotube, and a conductive grid. The first bus electrode 112 and the second bus electrode 142 may have a same structure or different structures, and may be made of a same material or different materials.

The sheet resistance of the first conductive electrode 111 may be 5 to 1000 times the sheet resistance of the first bus electrode 112. The first conductive electrode 111 and the first bus electrode 112 may have a same structure or different structures. When the first conductive electrode 111 and the first bus electrode 112 have a same structure, the first conductive electrode 111 and the first bus electrode 112 may be made of a same material or different materials. When a type and a material of the first conductive electrode 111 are the same as those of the first bus electrode 112, the first bus electrode 112 has a larger thickness or density than the first conductive electrode 111. The sheet resistance of the second conductive electrode 141 may be 5 to 1000 times the sheet resistance of the second bus electrode 142. The second conductive electrode 141 and the second bus electrode 142 may have a same structure or different structures. When the second conductive electrode 141 and the second bus electrode 142 have a same structure, the second conductive electrode 141 and the second bus electrode 142 may be made of a same material or different materials. When a type and a material of the second conductive electrode 141 are the same as those of the second bus electrode 142, the second bus electrode 142 has a larger thickness and/or density than the second conductive electrode 141.

In this embodiment of this application, the light absorption layer 130 may be an organic layer, a perovskite layer, a quantum dot layer, or the like. An organic light absorption layer 130 includes a two-element or multi-element blended film of at least one electron donor material and at least one electron acceptor material. The electron donor material may be at least one of polymers PTB7-Th, PBDB-T, PM6, and D 18, and derivatives. The electron acceptor material may be at least one of materials PCBM, ITIC, and Y6, and derivatives. When the light absorption layer 130 is the perovskite layer, a material may include one or more of methylammonium lead iodide, formamidinium lead iodide, cesium lead iodine, and three-dimensional and two-dimensional perovskites with multiple composite cations and composite anions. When the light absorption layer 130 is the quantum dot layer, the material may include the foregoing perovskite quantum dots, lead sulfide (selenide), cadmium sulfide, indium phosphide, and the like. For example, a material of the light absorption layer 130 is P3HT:PC₆₁BM.

In this embodiment of this application, the first bus electrode 112 and the first conductive electrode 111 may be located on a same side of the light absorption layer 130, and the second bus electrode 142 and the second conductive electrode 141 may be located on the other side of the light absorption layer 130. In this way, the first electrode 110 is located on one side of the light absorption layer 130, and the second electrode 140 is located on the other side of the light absorption layer 130. The first conductive electrode 111 and the second conductive electrode 141 are disposed opposite to each other. The first bus electrode 112 and the second bus electrode 142 may also be disposed opposite to each other. The light absorption layer 130 may be further located between the first bus electrode 112 and the second bus electrode 142. Carriers generated in the light absorption layer 130 located between the first bus electrode 112 and the second bus electrode 142 may be directly transmitted to the first bus electrode 112 and the second bus electrode 142, and do not need to be transmitted to the first bus electrode 112 through the first conductive electrode 111 or transmitted to the second bus electrode 142 through the second conductive electrode 141, thereby shortening a transmission path, reducing a transmission loss, and improving carrier collection efficiency.

The second conductive electrode 141 may include a conductive grid, and therefore has a high conductivity. Certainly, the second bus electrode 142 may also include a conductive grid. The second bus electrode 142 and the second conductive electrode 141 are disposed on a same side of the light absorption layer 130. The conductive grid of the second conductive electrode 141 and the conductive grid of the second bus electrode may be formed through a same process, and no additional process is required. The second bus electrode 142 and the second conductive electrode 141 may each include a conductive grid. Alternatively, the second conductive electrode 141 includes a thin metal, and the second bus electrode 142 includes a conductive grid, so that the second electrode 140 is compatible with a conventional process and has a high conductivity.

The following uses an example in which the first conductive electrode 111 is a bottom electrode, the second conductive electrode 141 is a top electrode, the first bus electrode 112 and the first conductive electrode 111 may be located on a same side of the light absorption layer 130, and the second bus electrode 142 and the second conductive electrode 141 may be located on the other side of the light absorption layer 130. FIG. 9 is a flowchart of another manufacturing method of a solar cell component according to an embodiment of this application. The forming a first electrode 110, a light absorption layer 130, and a second electrode 140 on a substrate may specifically include the following steps.

S101: Form the first electrode 110 on the substrate 100, where the first electrode 110 includes the first conductive electrode 111 and the first bus electrode 112, as shown in FIG. 11.

S102: Form the light absorption layer 130 on the first electrode 110, as shown in FIG. 12.

S103: Form the second electrode 140 on the light absorption layer 130, where the second electrode 140 includes the second conductive electrode 141 and the second bus electrode 142, as shown in FIG. 2.

Specifically, the first conductive electrode 111 may include the first conductive grid 1111, as shown in FIG. 6. The first conductive grid 1111 may have both a conductivity and light transmission. The first conductive grid 1111 may be embedded into a transparent colloidal layer 115, to facilitate fastening of the first conductive grid 1111.

The first conductive electrode 111 may further include a first conductive modification layer 1112. The first conductive grid 1111 and the first conductive modification layer 1112 form a composite electrode. The first conductive modification layer 1112 is located on a side that is of the first conductive grid 1111 and that faces the light absorption layer 130. When the first conductive electrode 111 is the bottom electrode, the first conductive modification layer 1112 may be disposed on the first conductive grid 1111, to reduce a step and surface roughness between grid wires of the first conductive grid 1111 and the transparent colloidal layer 115, so that a flat film layer is formed on the first conductive electrode 111. A material of the first conductive modification layer 1112 may be at least one of a transparent conductive oxide, a metal nanowire, a conductive polymer, a carbon-based material, a thin metal, or the like. The conductive polymer can improve wettability of an active layer, and is conducive to forming a film on the active layer. However, the conductive polymer may not have a conductivity and light transmission at the same time, and the carbon-based material such as a carbon nanotube and graphene, and a metal nanowire may not have a conductivity and light transmission at the same time.

Specifically, the first bus electrode 112 may include a third conductive grid 1121. A density of the third conductive grid 1121 of the first bus electrode 112 is greater than a density of the first conductive grid 1111 of the first conductive electrode 111, to have a larger conductive area; and/or a thickness of the third conductive grid 1121 of the first bus electrode 112 is greater than a thickness of the first conductive grid 1111 of the first conductive electrode 111, to have a larger depth-width ratio, so that the sheet resistance of the first bus electrode 112 is less than the sheet resistance of the first conductive electrode 111. The third conductive grid 1121 may also be embedded into the transparent colloidal layer 115. The first bus electrode 112 may further include a third conductive modification layer 1122. The third conductive modification layer 1122 is located on a side that is of the third conductive grid 1121 and that faces the light absorption layer 130.

A conductive grid may be formed in a manner of nano-imprinting, hybrid printing, or the like. A non-conductive grid may be formed in a manner of nano-printing, screen printing, heat deposition, magnetron sputtering, or ion beam evaporation, or the like.

In S101, when the first conductive electrode 111 includes the first conductive grid 1111 and the first conductive modification layer 1112, and the first bus electrode 112 includes the third conductive grid 1121, the forming a first electrode 110 on a substrate may be specifically: first forming the first conductive grid 1111 and the third conductive grid 1121, and then forming the first conductive modification layer 1112 on the first conductive grid 1111. Certainly, when the first conductive modification layer 1112 is formed, the third conductive modification layer 1122 may be simultaneously formed on the third conductive grid 1121. In this way, the first conductive electrode 111 and the first bus electrode 112 may be simultaneously formed, thereby reducing a manufacturing process.

The first conductive grid 1111 and the third conductive grid 1121 may be formed in a manner of nano-imprinting, hybrid printing, or the like. When the first conductive modification layer 1112 is a transparent conductive oxide, the first conductive modification layer 1112 may be formed through a magnetron sputtering or deposition process. The first conductive grid 1111 and the third conductive grid 1121 are embedded into the transparent colloidal layer 115.

In S102, the light absorption layer 130 may be formed in a manner of spin coating, vapor plating, blade coating, or the like.

Specifically, the second conductive electrode 141 may be made of a thin metal, or may include a second conductive grid 1411. The second conductive grid 1411 may have both a conductivity and light transmission. The second conductive grid 1411 is configured to enhance a conductivity of the second conductive electrode 141. The second conductive grid 1411 may be embedded into a transparent colloidal layer 146, to facilitate fastening of the second conductive grid 1411.

When the second conductive electrode 141 includes the second conductive grid 1411, the second conductive electrode 141 may further include a second conductive modification layer 1412. The second conductive grid 1411 and the second conductive modification layer 1412 form a composite electrode. The second conductive modification layer 1412 is located on a side that is of the second conductive grid 1411 and that faces the light absorption layer 130. When the second conductive electrode 141 is the top electrode, the second conductive modification layer 1412 is located below the second conductive grid 1411, to reduce a step and surface roughness between grid wires of the second conductive grid 1411 and the transparent colloidal layer 146, and increase flatness of a surface that is of the second conductive electrode 141 and that faces the light absorption layer 130, so that the second conductive electrode 141 has a flat surface to be in contact with a film layer below. A material of the second conductive modification layer 1412 may be at least one of a transparent conductive oxide, a metal nanowire, a conductive polymer, a carbon-based material, a thin metal layer, or the like.

When the second conductive electrode 141 includes the second conductive grid 1411, the solar cell component may further include a first conductive adhesive 1413. The first conductive adhesive 1413 is located on a side that is of the second conductive grid 1411 and that faces the light absorption layer 130, that is, located between the second conductive grid 1411 and the light absorption layer 130, to increase conductivity efficiency between the second conductive grid 1411 and the light absorption layer 130. When the second conductive electrode 141 includes the second conductive modification layer 1412, the second conductive modification layer 1412 may be located on a side that is of the first conductive adhesive 1413 and that faces the second conductive grid 1411, or may be located on a side that is of the first conductive adhesive 1413 and that faces the light absorption layer 130. When the second conductive electrode 141 is the top electrode, the first conductive adhesive 1413 is disposed under the second conductive grid 1411, and the first conductive adhesive 1413 is a material layer that ensures close mechanical contact and electrical contact. A material of the first conductive adhesive 1413 may be a PEDOT:PSS doped with D-sorbitol, or the like.

Specifically, the second bus electrode 142 may include a fourth conductive grid 1421. A density of the fourth conductive grid 1421 of the second bus electrode 142 is greater than a density of the second conductive grid 1411 of the second conductive electrode 141, to have a larger conductive area; and/or a thickness of the fourth conductive grid 1421 of the second bus electrode 142 is greater than a thickness of the second conductive grid 1411 of the second conductive electrode 141, to have a larger depth-width ratio, so that the sheet resistance of the second bus electrode 142 is less than the sheet resistance of the second conductive electrode 141. A thickness of the conductive grid is a size perpendicular to a surface of the substrate 100, a depth is a size perpendicular to the surface of the substrate 100, and a width is a size parallel to the surface of the substrate 100. The fourth conductive grid 1421 may also be embedded into the transparent colloidal layer 146.

The second bus electrode 142 may further include a fourth conductive modification layer 1422. The fourth conductive modification layer 1422 is located on a side that is of the fourth conductive grid 1421 and that faces the light absorption layer 130. The solar cell component may further include a second conductive adhesive 1423. The second conductive adhesive 1423 is located on a side that is of the fourth conductive grid 1421 and that faces the light absorption layer 130.

In S103, when the second conductive electrode 141 includes the second conductive grid 1411, and the second bus electrode 142 includes the fourth conductive grid 1421, the second conductive grid 1411 and the fourth conductive grid 1421 may be simultaneously formed in a nano-imprinting manner, and the second conductive grid 1411 and the fourth conductive grid 1421 are bonded to the light absorption layer 130 through transfer printing such as bonding, rolling, electric aggregation, or other methods, to form the second electrode 140. The second conductive grid 1411 and the fourth conductive grid 1421 may be embedded into the transparent colloidal layer 146, as shown in FIG. 6.

When the second conductive electrode 141 does not include a conductive grid, and the second bus electrode 142 includes the fourth conductive grid 1421, the second conductive electrode 141 may be formed in a manner of nano-printing, screen printing, heat deposition, magnetron sputtering, or ion beam evaporation, then the fourth conductive grid 1421 is formed in a nano-imprinting manner, and the fourth conductive grid 1421 is bonded to the light absorption layer 130 through transfer printing such as bonding, rolling, electric aggregation, or other methods, to be formed on a periphery of the second conductive electrode 141.

Before the second conductive grid 1411 is formed on the light absorption layer 130, the first conductive adhesive 1413 may be further formed on the light absorption layer 130, and then the second conductive grid 1411 is formed on the first conductive adhesive 1413, so that the first conductive adhesive 1413 is located between the second conductive grid 1411 and the light absorption layer 130. Specifically, the first conductive adhesive 1413 and the second conductive adhesive 1423 may be simultaneously formed, and may be formed through a process of spin coating or blade coating.

Before the second conductive grid 1411 is formed on the light absorption layer 130, the second conductive modification layer 1412 may be further formed on the light absorption layer 130, and then the second conductive grid 1411 is formed on the second conductive modification layer 1412, so that the second conductive modification layer 1412 is located between the second conductive grid 1411 and the light absorption layer. Specifically, the fourth conductive modification layer 1422 and the second conductive modification layer 1412 may be simultaneously formed, and may be formed through a process of magnetron sputtering or deposition.

The first conductive adhesive 1413 may be formed before the second conductive modification layer 1412, or may be formed after the second conductive modification layer 1412.

In this embodiment of this application, the first bus electrode 112, the second bus electrode 142, and the first conductive electrode 111 may be located on a same side of the light absorption layer 130, and the second conductive electrode 141 is located on the other side of the light absorption layer 130. The second conductive electrode 141 is electrically connected to the second bus electrode 142 through an interconnection structure. In this way, the first bus electrode 112 and the second bus electrode 142 may be formed through a same process. Compared with a conventional technology in which a first electrode 110 includes a first conductive electrode 111 and a second electrode 140 includes a second conductive electrode 141, only one process needs to be added to form both the first bus electrode 112 and the second bus electrode 142 in this embodiment of this application, thereby simplifying the process and reducing costs.

The first bus electrode 112, the second bus electrode 142, and the first conductive electrode 111 are located on the same side of the light absorption layer 130, the first bus electrode 112 is located on the periphery of the first conductive electrode 111, and the second bus electrode 142 is located on the periphery of the second conductive electrode 141. To facilitate electrical connection between the first bus electrode 112 and the first conductive electrode 111, the second bus electrode 142 may be disposed on a periphery of the first bus electrode 112, and the second bus electrode 142 may partially or completely surround the first bus electrode 112. The first bus electrode 112 and the second bus electrode 142 are not electrically connected. A specific distance needs to be set between the first bus electrode 112 and the second bus electrode 142, to prevent a short circuit between the first electrode 110 and the second electrode 140. Specifically, a distance range between the first bus electrode 112 and the second bus electrode 142 is not limited to 0.1 mm to 10 mm. An isolation structure 114 may be disposed between the first bus electrode 112 and the second bus electrode 142. The isolation structure may be the transparent colloidal layer 115, or may be the light absorption layer 130, or may be a laminated layer of multiple layers of the first carrier transport layer 150, the light absorption layer 130, and the second carrier transport layer 160.

The first conductive electrode 111 and the second conductive electrode 141 may be disposed in parallel, and both are located in a plane parallel to the surface of the substrate 100. The interconnection structure 143 extends from the periphery of the second conductive electrode 141 to the first conductive electrode 111, and is connected to the second bus electrode 142 located on the periphery of the first conductive electrode 111. An area of the second conductive electrode 141 is greater than an area of the first conductive electrode 111. The first conductive electrode 111 and the first bus electrode 112 are disposed facing the second conductive electrode 141 in a direction perpendicular to the surface of the substrate 100. The light absorption layer 130 may be further disposed between the first bus electrode 112 and the first conductive electrode 111. Carriers generated in the light absorption layer 130 located between the first bus electrode 112 and the first conductive electrode 111 may be directly transmitted to the first bus electrode 112 and the second conductive electrode 141, and do not need to be transmitted to the first bus electrode 112 through the first conductive electrode 111, thereby shortening a transmission path, reducing a transmission loss, and improving carrier collection efficiency.

The first bus electrode 112 and the second bus electrode 142 may each include a conductive grid, and the second bus electrode 142 and the first electrode 110 are disposed on a same side of the light absorption layer 130, that is, a side close to the substrate 100. Both the first bus electrode 112 and the second bus electrode 142 are in contact with the substrate 100. In this way, the first bus electrode 112 and the second bus electrode 142 may be simultaneously formed, and no additional step needs to be added to form the second bus electrode 142 after the light absorption layer 130 is formed, thereby reducing a quantity of processes.

The following uses an example in which the first conductive electrode 111 is a bottom electrode, the second conductive electrode 141 is a top electrode, the first bus electrode 112, the second bus electrode 142, and the first conductive electrode 111 may be located on a same side of the light absorption layer 130, and the second conductive electrode 141 is located on the other side of the light absorption layer 130. FIG. 10 is a flowchart of still another manufacturing method of a solar cell component according to an embodiment of this application. The forming a first electrode 110, a light absorption layer 130, and a second electrode 140 on a substrate may specifically include the following steps.

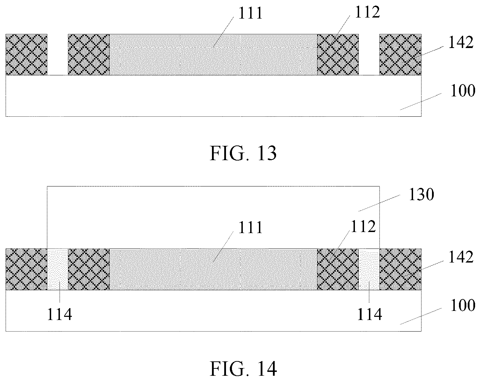

S111: Form, on the substrate, the first electrode 110 and the second bus electrode 142 on a periphery of the first electrode 110, where the first electrode 110 includes the first conductive electrode 111 and the first bus electrode 112, and the second bus electrode 142 is located on the periphery of the first bus electrode 112, as shown in FIG. 13.

S112: Form the light absorption layer 130 on the first conductive electrode 111 and the first bus electrode 112, as shown in FIG. 14.

S113: Form the second conductive electrode 141 on the light absorption layer 130, and form, on the periphery of the second conductive electrode 141, the interconnection structure 143 that electrically connects the second conductive electrode 141 and the second bus electrode 142, as shown in FIG. 3.

Specifically, the first conductive electrode 111 may include a first conductive grid 1111, and the first conductive electrode 111 may further include a first conductive modification layer 1112. The first conductive grid 1111 and the first conductive modification layer 1112 form a composite electrode, and the first conductive modification layer 1112 is located on a side that is of the first conductive grid 1111 and that faces the light absorption layer 130. The first conductive grid 1111 may be embedded into a transparent colloidal layer 115.

Specifically, the first bus electrode 112 may include a third conductive grid 1121. When the first conductive electrode 111 includes the first conductive grid 1111, a density of the third conductive grid 1121 of the first bus electrode 112 is greater than a density of the first conductive grid 1111 of the first conductive electrode 111, to have a larger conductive area; and/or a thickness of the third conductive grid 1121 of the first bus electrode 112 is greater than a thickness of the first conductive grid 1111 of the first conductive electrode 111, to have a larger depth-width ratio, so that the sheet resistance of the first bus electrode 112 is less than the sheet resistance of the first conductive electrode 111. The third conductive grid 1121 may also be embedded into the transparent colloidal layer 115. The first bus electrode 112 may further include a third conductive modification layer 1122. The third conductive modification layer 1122 is located on a side that is of the third conductive grid 1121 and that faces the light absorption layer 130.

Specifically, the second bus electrode 142 may include a fourth conductive grid 1421. When the second conductive electrode 141 includes the second conductive grid 1411, a density of the fourth conductive grid 1421 of the second bus electrode 142 is greater than a density of the second conductive grid 1411 of the second conductive electrode 141, to have a larger conductive area; and/or a thickness of the fourth conductive grid 1421 of the second bus electrode 142 is greater than a thickness of the second conductive grid 1411 of the second conductive electrode 141, to have a larger depth-width ratio, so that the sheet resistance of the second bus electrode 142 is less than the sheet resistance of the second conductive electrode 141. The fourth conductive grid 1421 may also be embedded into the transparent colloidal layer 115. The second bus electrode 142 may further include a fourth conductive modification layer 1422, and the fourth conductive modification layer 1422 is located on a side that is of the fourth conductive grid 1421 and that faces the light absorption layer 130.

Specifically, the second conductive electrode 141 may include the second conductive grid 1411, or may be made of a thin metal. The second conductive electrode 141 made of the thin metal can be better compatible with a conventional process.

In S111, the first bus electrode 112 and the second bus electrode 142 may be formed in a manner of nano-imprinting, hybrid printing, or the like. The first conductive electrode 111 and the first bus electrode 112 may be simultaneously formed, or may be separately formed. When the first conductive electrode 111 includes the first conductive grid 1111, the first conductive electrode 111 may also be formed in a manner of nano-imprinting, hybrid printing, or the like. The second bus electrode 142 may include the fourth conductive grid 1421 and the fourth conductive modification layer 1422 on the fourth conductive grid 1421. The fourth conductive modification layer 1422, the first conductive modification layer 1112, and the third conductive modification layer 1122 may be simultaneously formed, and may be formed through a process of magnetron sputtering or deposition.

In S112, the light absorption layer 130 may be formed in a manner of spin coating, vapor plating, blade coating, or the like.

In S113, the second conductive electrode 141 may be formed in a manner of spin coating, thermal evaporation, magnetron sputtering, ion beam evaporation, transfer printing, or the like. The interconnection structure 143 and the second conductive electrode 141 may be simultaneously formed, or may be separately formed.

In this embodiment of this application, a first carrier transport layer 150 may be further disposed between the first conductive electrode 111 and the light absorption layer 130, and a second carrier transport layer 160 may be further disposed between the second conductive electrode 141 and the light absorption layer 130, as shown in FIG. 4 and FIG. 5. One of the first carrier transport layer 150 and the second carrier transport layer 160 is an electron transport layer, and the other one is a hole transport layer. In other words, after generating an electron-hole pair, the light absorption layer 130 transmits electrons to the first electrode 110 or the second electrode 140 through the electron transport layer, and transmits holes to the second electrode 140 or the first electrode 110 through the hole transport layer. The electron transport layer includes n-type metal oxides, conjugate and non-conjugate polymers, or small molecules, such as PFN, PDINO, or PEI, and derivatives, or zinc oxide (ZnO) or titanium oxide (TiO₂). The hole transport layer includes p-type metal oxides, conjugate and non-conjugate polymers, or small molecules, such as PEDOT:PSS, PTAA, or spiro-OMeTAD, or molybdenum oxide (MoOs) or nickel oxide (NiOₓ). A thickness range of the electron transport layer is 30 nm to 100 nm, and a thickness range of the hole transport layer is 10 nm to 50 nm. The first carrier transport layer 150 and the second carrier transport layer 160 may also be formed in a manner of spin coating, vapor plating, blade coating, or the like.

In this embodiment of this application, an anti-reflection film, another photonic crystal structure, or the like may be further included, is disposed on a side that is of the solar cell component and that is far away from the substrate 100, or disposed on a side that is of the substrate 100 and that is far away from the light absorption layer 130. The anti-reflection film is configured to increase light transmission, and the photonic crystal structure is configured to alternatively increase light transmission or reflection, to filter light that is incident to the light absorption layer 130. For example, when the first conductive electrode 111 is the bottom electrode, the anti-reflection film may cover the second electrode 140. A material of the anti-reflection film may be, for example, molybdenum oxide.

This embodiment of this application provides a manufacturing method of a solar cell component. The method may include: forming the first electrode, the second electrode, and the light absorption layer on the substrate. The first electrode includes the first conductive electrode, and the second electrode includes the second conductive electrode. The light absorption layer is located between the first conductive electrode and the second conductive electrode. The first electrode further includes the first bus electrode. The first bus electrode is connected to the periphery of the first conductive electrode, and the sheet resistance of the first bus electrode is less than the sheet resistance of the first conductive electrode. The first bus electrode is electrically connected to the first conductive electrode. In other words, the sheet resistance of the peripheral region of the first electrode is less than the sheet resistance of the central region of the first electrode. In this way, compared with the case in which the first electrode includes only the single first conductive electrode, the sheet resistance of the first electrode is reduced. After the optical charge is transmitted to the first electrode, the optical charge can be quickly converged to the periphery, thereby reducing the sheet resistance loss caused by long-distance uneven transmission of the optical charge, and facilitating collection of the optical charge. Therefore, optical-to-electrical conversion efficiency of the solar cell component can be improved.

Based on the solar cell component provided in embodiments of this application, an embodiment of this application further provides an electronic device. The electronic device includes a circuit board and a solar cell component connected to the circuit board. The solar cell component may be any solar cell component provided above. The circuit board may be a printed circuit board (PCB). Certainly, the circuit board may alternatively be a flexible circuit board (FPC), or the like. The circuit board is not limited in this embodiment. Optionally, the electronic device is user equipment or a terminal device of different types such as a computer, a mobile phone, a tablet computer, a wearable device, and an in-vehicle device. The electronic device may alternatively be a network device such as a base station.

Optionally, the electronic device further includes a package substrate, where the package substrate is fastened to the printed circuit board PCB through solder balls, and the solar cell component is fastened to the package substrate through solder balls.

Embodiments in the specification are all described in a progressive manner, same or similar parts between embodiments may be mutually referenced, and each embodiment focuses on a difference from other embodiments.

The foregoing provides specific implementations of this application. It should be understood that the foregoing embodiments are merely intended for describing the technical solutions of this application, but not for limiting this application. Although this application is described in detail with reference to the foregoing embodiments, a person of ordinary skill in the art should understand that modifications can still be made to the technical solutions described in the foregoing embodiments or equivalent replacements can still be made to some technical features thereof, without departing from the scope of the technical solutions of embodiments of this application.

## Claims

1. A solar cell component, comprising:
a first electrode, a second electrode, and a light absorption layer, wherein the first electrode comprises a first conductive electrode, and the second electrode comprises a second conductive electrode;
the light absorption layer is located between the first conductive electrode and the second conductive electrode; and
the first electrode further comprises a first bus electrode, the first bus electrode is connected to a periphery of the first conductive electrode, and a sheet resistance of the first bus electrode is less than a sheet resistance of the first conductive electrode.

2. The component according to claim 1, wherein the second electrode further comprises a second bus electrode, the second bus electrode is connected to a periphery of the second conductive electrode, and a sheet resistance of the second bus electrode is less than a sheet resistance of the second conductive electrode.

3. The component according to claim 2, wherein the first bus electrode and the first conductive electrode are located on a same side of the light absorption layer, and the second bus electrode and the second conductive electrode are located on the other side of the light absorption layer.

4. The component according to claim 3, wherein the light absorption layer is further located between the first bus electrode and the second bus electrode.

5. The component according to claim 3 or 4, wherein the component further comprises a substrate, the first conductive electrode is in contact with the substrate, the second conductive electrode is far away from the substrate, the second conductive electrode comprises a second conductive grid, and the second conductive grid is configured to enhance conductivity of the second conductive electrode.

6. The component according to claim 5, wherein the second conductive electrode further comprises a second conductive modification layer, and the second conductive modification layer is located on a side that is of the second conductive grid and that faces the light absorption layer, and is configured to increase flatness of a surface that is of the second conductive electrode and that faces the light absorption layer.

7. The component according to claim 6, wherein the second conductive modification layer is made of at least one of the following types: a transparent conductive oxide, a metal nanowire, a conductive polymer, a carbon-based material, and a thin-film metal.

8. The component according to any one of claims 5 to 7, comprising a first conductive adhesive, wherein the first conductive adhesive is disposed between the second conductive grid and the light absorption layer, to increase conductivity efficiency between the second conductive grid and the light absorption layer.

9. The component according to claim 2, wherein the first bus electrode, the second bus electrode, and the first conductive electrode are located on a same side of the light absorption layer, the second conductive electrode is located on the other side of the light absorption layer, and the second conductive electrode is electrically connected to the second bus electrode through an interconnection structure.

10. The component according to claim 9, wherein the second conductive electrode is parallel to the first conductive electrode, and the interconnection structure extends from the periphery of the second conductive electrode to the first conductive electrode, and is connected to the second bus electrode located on the periphery of the first conductive electrode.

11. The component according to claim 9 or 10, wherein the component further comprises a substrate, both the first bus electrode and the second bus electrode are in contact with the substrate, the first bus electrode comprises a third conductive grid, and the second bus electrode comprises a fourth conductive grid.

12. The component according to any one of claims 1 to 11, wherein
the first conductive electrode comprises a first conductive grid; or
the first conductive electrode comprises a first conductive grid and a first conductive modification layer located on a side that is of the first conductive grid and that faces the light absorption layer.

13. The component according to any one of claims 1 to 12, wherein a first carrier transport layer is disposed between the first electrode and the light absorption layer, and a second carrier transport layer is disposed between the second electrode and the light absorption layer.

14. The component according to any one of claims 2 to 13, wherein the sheet resistance of the first conductive electrode is 5 to 1000 times the sheet resistance of the first bus electrode, and the sheet resistance of the second conductive electrode is 5 to 1000 times the sheet resistance of the second bus electrode.

15. A manufacturing method of a solar cell component, comprising:
forming a first electrode, a light absorption layer, and a second electrode on a substrate, wherein the first electrode comprises a first conductive electrode, and the second electrode comprises a second conductive electrode;
the light absorption layer is located between the first conductive electrode and the second conductive electrode; and
the first electrode further comprises a first bus electrode, the first bus electrode is connected to a periphery of the first conductive electrode, and a sheet resistance of the first bus electrode is less than a sheet resistance of the first conductive electrode.

16. The method according to claim 15, wherein the second electrode further comprises a second bus electrode, the second bus electrode is connected to a periphery of the second conductive electrode, and a sheet resistance of the second bus electrode is less than a sheet resistance of the second conductive electrode.

17. The method according to claim 16, wherein the second bus electrode and the second conductive electrode are located on a same side of the light absorption layer, and the second bus electrode and the second conductive electrode are located on the other side of the light absorption layer.

18. The method according to claim 17, wherein the light absorption layer is further located between the first bus electrode and the second bus electrode.

19. The method according to claim 17 or 18, wherein the first conductive electrode is in contact with the substrate, the second conductive electrode is far away from the substrate, the second conductive electrode comprises a second conductive grid, and the second conductive grid is configured to enhance conductivity of the second conductive electrode; and the forming a first electrode, a light absorption layer, and a second electrode on a substrate comprises:
forming the first electrode on the substrate;
forming the light absorption layer on the first electrode; and
forming the second electrode on the light absorption layer.

20. The method according to claim 19, wherein the second conductive electrode further comprises a second conductive modification layer, and the second conductive modification layer is located on a side that is of the second conductive grid and that faces the light absorption layer, and is configured to increase flatness of a surface that is of the second conductive electrode and that faces the light absorption layer.

21. The method according to any one of claims 19 and 20, wherein before the second conductive grid is formed, the method further comprises:
forming a first conductive adhesive on the light absorption layer, to increase conductivity efficiency between the second conductive grid and the light absorption layer.

22. The method according to claim 16, wherein the first bus electrode, the second bus electrode, and the first conductive electrode are located on a same side of the light absorption layer, the second conductive electrode is located on the other side of the light absorption layer, and the second conductive electrode is electrically connected to the second bus electrode through an interconnection structure.

23. The method according to claim 22, wherein the second conductive electrode is parallel to the first conductive electrode, and the interconnection structure extends from the periphery of the second conductive electrode to the first conductive electrode, and is connected to the second bus electrode located on the periphery of the first conductive electrode.

24. The method according to claim 22 or 23, wherein both the first bus electrode and the second bus electrode are in contact with the substrate; the first bus electrode comprises a third conductive grid, and the second bus electrode comprises a fourth conductive grid; and the forming a first electrode, a light absorption layer, and a second electrode on a substrate comprises:
forming, on the substrate, the first conductive electrode, the first bus electrode, and the second bus electrode on a periphery of the first bus electrode;
forming the light absorption layer on the first conductive electrode and the first bus electrode; and
forming the second conductive electrode on the light absorption layer, and forming, on the periphery of the second conductive electrode, the interconnection structure that electrically connects the second conductive electrode and the second bus electrode.

25. The method according to any one of claims 15 to 24, wherein
the first conductive electrode comprises a first conductive grid; or
the first conductive electrode comprises a first conductive grid and a first conductive modification layer located on a side that is of the first conductive grid and that faces the light absorption layer.

26. The method according to any one of claims 15 to 25, further comprising:
forming a first carrier transport layer between the first electrode and the light absorption layer, and forming a second carrier transport layer between the second electrode and the light absorption layer.

27. An electronic device, comprising a circuit board and the solar cell component according to any one of claims 1 to 14, wherein the solar cell component is connected to the circuit board.
